# EUROPÄISCHE PATENTSCHRIFT

(11) **EP 2 577 771 B1**
(45) Veröffentlichungstag und Bekanntmachung des Hinweises auf die Patenterteilung: **29.10.2014**
(21) Anmeldenummer: 11727141.1
(22) Anmeldetag: 01.06.2011
(51) Int. Cl.: H01M 2/10, G01D 11/24, G01K 1/08, H05K 5/02

(54) **FELDGERÄT ZUR PROZESSINSTRUMENTIERUNG**
FIELD DEVICE FOR PROCESS INSTRUMENTATION
APPAREIL DE TERRAIN POUR L'INSTRUMENTATION DES PROCÉDÉS

(30) Priorität: 02.06.2010 DE 102010022530
(43) Veröffentlichungstag der Anmeldung: 10.04.2013
(73) Patentinhaber: Siemens Aktiengesellschaft, 80333 München (DE)
(72) Erfinder: BALLE, Patrick, 76316 Malsch (DE); GROSS, Stefan, 76706 Dettenheim (DE)
(86) Internationale Anmeldenummer: PCT/EP2011/059050
(87) Internationale Veröffentlichungsnummer: WO 2011/151380

(56) Entgegenhaltungen:
- EP-A1- 0 565 217
- WO-A2-2007/098222
- DE-A1- 4 323 891
- JP-A- 59 058 756

## Beschreibung

Die Erfindung betrifft ein Feldgerät zur Prozessinstrumentierung, insbesondere einen Messumformer, ein Stellglied oder ein mobiles Bediengerät, welches für einen Einsatz in explosionsgefährdeten Bereichen geeignet ist, gemäß dem Oberbegriff des Anspruchs 1.

In prozesstechnischen Anlagen werden zur Steuerung von Prozessen vielfältige Feldgeräte für die Prozessinstrumentierung eingesetzt. Messumformer dienen zur Erfassung von Prozessvariablen, wie beispielsweise Temperatur, Druck, Durchflussmenge, Füllstand, Dichte oder Gaskonzentration eines Mediums. Durch Stellglieder kann der Prozessablauf in Abhängigkeit von erfassten Prozessvariablen beispielsweise entsprechend einer von einer Leitstation vorgegebenen Strategie oder gesteuert durch ein Automatisierungsgerät, zum Beispiel eine speicherprogrammierbare Steuerung, beeinflusst werden. Als Beispiele für Stellglieder seien ein Regelventil, eine Heizung oder eine Pumpe genannt. Damit eine Leitstation oder ein Automatisierungsgerät mit der Prozessperipherie, das heißt mit den Messumformern oder den Stellgliedern oder weiteren prozessnahe angeordneten Geräten, kommunizieren können, sind diese bisher meist über ein drahtgebundenes Kommunikationsnetzwerk miteinander verbunden. Über dieses Netzwerk nehmen Leitstation oder Automatisierungsgerät beispielsweise Daten aus den Messumformern auf und geben Steuerinformationen an die Stellglieder aus. Der damit verbundene Verdrahtungsaufwand kann weitgehend reduziert werden, wenn das drahtgebundene Kommunikationsnetzwerk durch ein funkbasiertes Netzwerk ersetzt wird. Feldgeräte, zum Beispiel Messumformer, Stellglieder, Transportfahrzeuge oder Bediengeräte, werden dazu mit einer Funkschnittstelle ausgestattet, damit sie beispielsweise über Access Points oder Switches an der drahtlosen Kommunikation mit der Leitstation oder dem Automatisierungsgerät teilnehmen können. Wird eine Elektronikeinheit des Feldgeräts durch eine Batterie mit der zu ihrem Betrieb erforderlichen Energie versorgt, kann das Feldgerät völlig ohne Kabelanschluss betrieben werden.

Ein derartiges Feldgerät ist beispielsweise aus der US 6,795,319 B2 bekannt. Damit das Feldgerät in explosionsgefährdeten Bereichen eingesetzt werden kann, befindet sich seine Elektronikeinheit in einem gekapselten Gehäuse und ein Energieversorgungsmodul ist zur Vermeidung einer Funkenbildung eigensicher ausgeführt. Um den Anforderungen der Zündschutzart Eigensicherheit zu genügen, ist eine in das Energieversorgungsmodul eingesetzte Batterie vergossen und kann in nachteiliger Weise daher nicht bei Bedarf ausgetauscht werden. Ein Austausch des vollständigen Energieversorgungsmoduls ist dagegen mit vergleichsweise hohem Aufwand verbunden.

Aus der WO 2007/098222 A2 ist ein weiteres Feldgerät zur Prozessinstrumentierung bekannt, welches für einen Einsatz in explosionsgefährdeten Bereichen geeignet ist. Zur Energieversorgung des Feldgeräts dient eine Batterie, die in einem Batteriefach angeordnet ist. Zur Entnahme einer verbrauchten Batterie wird ein Deckel des Batteriefachs entfernt und anschließend die Batterie aus dem Batteriefach entnommen. Erst mit der Entnahme der Batterie und damit bei bereits geöffnetem Batteriefach wird ein Stromkreis zur Energieversorgung des Feldgeräts unterbrochen.

Der Erfindung liegt die Aufgabe zugrunde, ein Feldgerät zur Prozessinstrumentierung zu schaffen, welches für einen Einsatz in explosionsgefährdeten Bereichen geeignet ist und das einen besonders einfachen Batteriewechsel ermöglicht.

Zur Lösung dieser Aufgabe weist das neue Feldgerät der eingangs genannten Art die im kennzeichnenden Teil des Anspruchs 1 angegebenen Merkmale auf. In den abhängigen Ansprüchen sind vorteilhafte Weiterbildungen der Erfindung beschrieben.

Die Erfindung beruht auf der Erkenntnis, dass austauschbare Standardbatterien nur dann bei batteriebetriebenen Feldgeräten, welche für einen Einsatz in explosionsgefährdeten Bereichen vorgesehen sind, verwendet werden können, wenn durch die Gestaltung des Batteriefachs sichergestellt ist, dass während des gesamten Vorgangs des Batteriewechsels ein Zündschutz gewährleistet bleibt und somit sichergestellt ist, dass zu jedem Zeitpunkt die Anforderungen für einen Einsatz in explosionsgefährdeten Bereichen erfüllt sind. Standardbatterien sind beispielsweise Primärzellen, die nur einmal entladen und nicht wieder aufgeladen werden können, in den von der ANSI genormten Baugrößen AAA, AA, C oder D, die häufig als Mikro-, Mignon-, Baby- bzw. Monozellen bezeichnet werden. Derartige Primärzellen sind am Markt gut verfügbar und zu vergleichsweise günstigen Kosten erhältlich. Als Standardbatterien werden ebenso wiederaufladbare Batterien in handelsüblichen Bauformen, zum Beispiel NiCd- (Nickel-Cadmium-), NiMH- (Nickel-Metallhydrid-) oder LiIon- (Lithium-Ionen-) Akkumulatoren angesehen. Gegenüber einem Energieversorgungsmodul, in welchem die Batterie vergossen ist und das eventuell einen speziell abgedichteten Kontaktstecker besitzt, so dass im Bereich der Steckkontakte eine Art abgeschlossene Kammer entsteht, ist ein Batteriewechsel nun sehr einfach und mit vergleichsweise geringen Kosten durchführbar. Zudem würde die Verwendung eines Energieversorgungsmoduls eine umweltgerechte Entsorgung erschweren, da dieses aus verschiedenen Materialien zusammengesetzt ist, während bei dem neuen Feldgerät lediglich die verbrauchte Batterie entsorgt werden muss.

Durch die Ausführung des Batterieschachts, in welchem die Batterie nur lagerichtig eingeführt werden kann, wird vermieden, dass bei der Handhabung der Batterie Batteriekontakte unbeabsichtigt kurzgeschlossen werden können. Durch geeignete Auslegung eines Stromkreises zur Versorgung der Elektronikeinheit mit der von der Batterie gelieferten Hilfsenergie ist in vorteilhafter Weise sichergestellt, dass immer dann, wenn das Batteriefach aufgrund seines Öffnungszustandes den Anforderungen für einen Einsatz in explosionsgefährdeten Bereichen nicht mehr genügen würde, der Stromkreis bereits geöffnet ist und somit eine Funkenbildung zuverlässig vermieden wird.

Dabei ist der Gehäuseteil des Batteriefachs mit dem Deckel durch einen Schraubverschluss verschließbar und ein elektrischer Kontakt im Versorgungsstromkreis stellt nur dann eine Verbindung her, wenn der Schraubverschluss derart weit eingedreht ist, dass die Anforderungen für einen Einsatz in explosionsgefährdeten Bereichen aufgrund der besonderen Eigenschaft des Schraubverschlusses erfüllt sind, dass dieser die Funktion einer ausreichenden Zünd- oder Flammensperre besitzt. Dies kann durch geeignete Dimensionierung des Gewindes erreicht werden, wie beispielsweise durch geeignete Festlegung der im Gewinde verbleibenden Spaltbreite, des Materials, der Gewindehöhe usw. Das Gewinde wird vorzugsweise so ausgeführt, dass das Batteriefach bereits bei derart weit eingedrehtem Schraubverschluss als druckfeste Kapselung angesehen werden kann.

Der elektrische Kontakt ist als Kontaktfahne ausgeführt, welche beim Schließen des Schraubverschlusses einen Gegenkontakt zum Schließen des Versorgungsstromkreises automatisch kontaktiert und zu Beginn eines Öffnungsvorgangs des Schraubverschlusses den Gegenkontakt wieder freigibt. Dies hat den Vorteil, dass kein zusätzlicher Schalter zum Öffnen und Schließen des Versorgungsstromkreises beim Batterieaustausch benötigt wird und somit die Herstellungskosten des Batteriefachs reduziert werden.

In vorteilhafter Weise wird eine besonders einfache Implementierung des Batteriefachs erreicht, wenn die Batterie im Wesentlichen zylinderförmig ist und sich jeweils ein Batteriekontakt an den Grundflächen des Zylinders befindet. Die Batterie wird dann mit einem ersten Batteriekontakt voraus bei geöffnetem Deckel in den Batterieschacht eingeführt. Ein Deckel, der im Wesentlichen becherförmig ausgebildet ist, wobei sich das Gewinde des Deckels zur Realisierung des Schraubverschlusses im Bereich des Becherrands befindet, ist an seiner Innenseite des Becherbodens mit einem elektrisch leitfähigen Element, insbesondere einer metallischen Platte, zur Kontaktierung des zweiten Batteriekontaktes versehen. Das elektrisch leitfähige Element bildet gleichzeitig den Gegenkontakt für die Kontaktfahne. Als Material ist beispielsweise Kupfer geeignet.

In einer weiteren, besonders vorteilhaften Ausgestaltung dient jeweils eine Feder im Batterieschacht und an der Kontaktfahne im geschlossenen Zustand des Batteriefachs zum Andrücken der Batterie bzw. der Kontaktfahne gegen das elektrisch leitfähige Element. Dadurch wird eine dauerhafte und gute Kontaktierung erreicht.

Anhand der Zeichnungen, in denen ein Ausführungsbeispiel der Erfindung dargestellt ist, werden im Folgenden die Erfindung sowie Ausgestaltung und Vorteile näher erläutert. Es zeigen:
- Figur 1: ein Feldgerät mit halb geöffnetem Batteriefach und
- Figur 2: das Feldgerät gemäß Figur 1 mit geschlossenem Batteriefach.

In den Figuren sind gleiche Teile mit gleichen Bezugszeichen versehen.

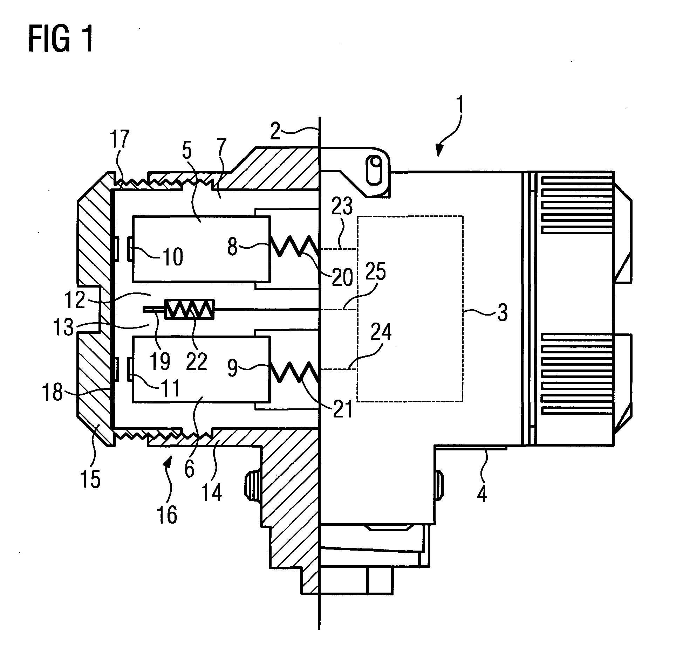

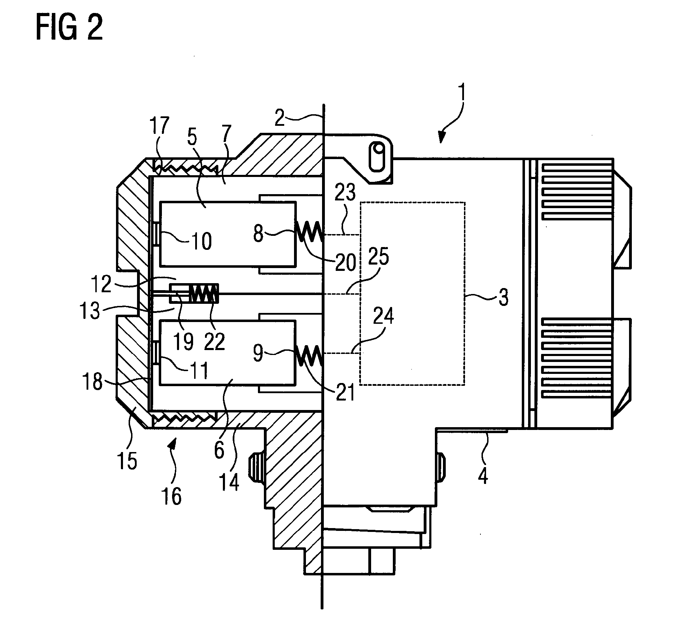

Als Beispiel für ein Feldgerät zur Prozessinstrumentierung, welches für einen Einsatz in explosionsgefährdeten Bereichen dargestellt ist, zeigen die Figuren 1 und 2 einen Messumformer 1. In der jeweils rechten Hälfte der Figuren 1 und 2, das heißt rechts von einer Linie 2, ist eine Außenansicht, in der jeweils linken Hälfte ein Schnittbild des jeweiligen Teils des Messumformers 1 dargestellt. Eine Elektronikeinheit 3 befindet sich im Inneren eines Gehäuses 4 des Messumformers 1. Die Elektronikeinheit 3 wurde mit durchbrochenen Linien gezeichnet um zu verdeutlichen, dass sie aufgrund ihrer Anordnung im Inneren des Gehäuses 4 in der Außenansicht eigentlich nicht sichtbar wäre.

Der Messumformer 1 ist batteriebetrieben. Die zur Versorgung der Elektronikeinheit 3 mit der zu ihrem Betrieb erforderlichen Hilfsenergie erfolgt durch zwei Batterien 5 und 6, die sich im Inneren eines Batteriefachs 7 befinden. Das Batteriefach 7 befindet sich in einem Gehäuseteil 14, das mit einem Deckel 15 durch einen Schraubverschluss 16 verschließbar ist. Der Deckel 15 ist im Wesentlichen becherförmig ausgebildet, wobei sich ein Gewinde 17 des Deckels 15 zur Realisierung des Schraubverschlusses 16 auf der Außenseite des Becherrands befindet. Die beiden Batterien 5 und 6 sind als austauschbare Standardbatterien der Baugröße D ausgeführt. Die Batterien 5 und 6 sind im Wesentlichen zylinderförmig und besitzen erste Kontakte 8 bzw. 9, hier die Minuspole, mit welchen voraus sie in das Batteriefach 7 eingeführt werden. An der jeweils gegenüberliegenden Grundfläche des Zylinders befinden sich zweite Batteriekontakte 10 bzw. 11, die Pluspole der Batterien 5 bzw. 6. Batterieschächte 12 und 13, die zur lagerichtigen Aufnahme der Batterien 5 bzw. 6 dienen, sind aufgrund ihrer Dimensionierung und der verwendeten Materialien so beschaffen, dass selbst bei ungeschickter Handhabung der Batterien 5 und 6 ein Kurzschluss der Kontakte 8 und 10 bzw. der Kontakte 9 und 11 unmöglich ist. An der Innenseite des Becherbodens des Deckels 15 ist eine Kupferplatte 18 angeordnet, welche im geschlossenen Zustand des Batteriefachs 7 zur Kontaktierung der Kontakte 10 und 11 der Batterien 5 bzw. 6 sowie zur Kontaktierung einer Kontaktfahne 19 dient, die in der Mitte des Batteriefachs 7 angeordnet ist. Mit Federn 20, 21 und 22 werden die Batterie 5, die Batterie 6 bzw. die Kontaktfahne 19 im geschlossenen Zustand des Batteriefachs 7, welcher in Figur 2 dargestellt ist, gegen die Platte 18 gedrückt. Die Federn 20...22 dienen zum Toleranzausgleich sowie zur Gewährleistung eines dauerhaften und guten Kontakts mit der Platte 18. Die Platte 18, die Kontaktfahne 19, die Federn 20...22 und Zuleitungen 23, 24 und 25 bilden einen Stromkreis zur Versorgung der Elektronikeinheit 3 mit der von den Batterien 5 und 6 gelieferten Hilfsenergie, die zum Betrieb der Elektronikeinheit 3 erforderlich ist.

Ist der Schraubverschluss 16, wie in Figur 2 dargestellt, vollständig eingedreht, so ist auch der Versorgungsstromkreis geschlossen und somit die Versorgung der Elektronikeinheit 3 sichergestellt. Eine Ausführung des Batteriefachs 7 als druckfeste Kapselung sorgt dafür, dass die Anforderungen für einen Einsatz des Feldgeräts 1 in explosionsgefährdeten Bereichen erfüllt werden. Diese Anforderungen werden selbst dann erfüllt, wenn der Schraubverschluss 16, wie in Figur 1 dargestellt, nur zur Hälfte eingedreht ist. Der im Schraubverschluss 16 verbleibende Spalt stellt nämlich eine Zünd- oder Flammensperre dar, die im Falle einer Entzündung eines Gases innerhalb des Batteriefachs 7 eine Übertragung der Flamme durch den Gewindespalt hindurch aus dem Feldgerät 1 heraus verhindert. Dabei wird die Erkenntnis ausgenützt, dass Flammen beim Durchlaufen des engen Gewindespalts an Energie verlieren und nicht mehr reaktionsfähig sind, somit zum Erlöschen gebracht werden. Das Auslöschen der Flammen wird dabei durch einen innigen Kontakt der Flamme mit den kühlenden Wänden des Gewindespalts und durch Druckabfall erzielt. Zur Realisierung einer zünddurchschlagsicheren Strecke ist der Gewindespalt ausreichend klein und die beim Öffnen des Versorgungsstromkreises in Eingriff verbleibende Höhe des Schraubverschlusses 16 ausreichend groß zu bemessen. Der Versorgungsstromkreis, die Höhe des Schraubverschlusses 16 und die geometrischen Abmessungen des Batteriefachs 7 mit den Batterien 5 und 6 sind also derart aufeinander abgestimmt, dass der Versorgungsstromkreis beim Schließen des Batteriefachs 7 erst dann geschlossen wird, wenn der Gehäuseteil 14 durch den Deckel 15 bereits so weit verschlossen ist, dass durch das Batteriefach 7 die Anforderungen für einen Einsatz in explosionsgefährdeten Bereichen erfüllt sind. Gleichzeitig wird durch die geeignete konstruktive Auslegung erreicht, dass der Versorgungsstromkreis beim Öffnen des Batteriefachs 7 bereits geöffnet ist, bevor der Gehäuseteil 14 durch den Deckel 15 bereits so weit geöffnet ist, dass durch das Batteriefach 7 die Anforderungen für einen Einsatz in explosionsgefährdeten Bereichen nicht mehr erfüllt sind. Es wird somit auf besonders einfache Weise sichergestellt, dass während des gesamten Batteriewechselvorgangs der Zündschutz bestehen bleibt.

## Patentansprüche

1. Feldgerät zur Prozessinstrumentierung, insbesondere Messumformer (1), Stellglied oder mobiles Bediengerät, welches für einen Einsatz in explosionsgefährdeten Bereichen geeignet ist,
mit einer Elektronikeinheit (3), die in einem Gehäuse (4) des Feldgeräts (1) angeordnet ist, und
mit zumindest einer austauschbaren Batterie (5, 6) zur Versorgung der Elektronikeinheit mit zu ihrem Betrieb erforderlicher Hilfsenergie,
wobei die zumindest eine Batterie (5, 6) in einem Batteriefach (7) angeordnet ist, welches sich in einem Gehäuseteil (14) des Feldgeräts (1) mit zum Batterieaustausch abnehmbaren Deckel (15) befindet, und
wobei der zu öffnende Gehäuseteil (14) und/oder der Deckel (15) einen Batterieschacht (12, 13) zur lagerichtigen Aufnahme der zumindest einen Batterie (5, 6) aufweist,
**dadurch gekennzeichnet, dass** ein elektrischer Kontakt (18, 19) in einem Stromkreis (18...25) zur Versorgung der Elektronikeinheit (3) mit der von der zumindest einen Batterie (5, 6) gelieferten Hilfsenergie als Kontaktfahne (19) ausgeführt ist, welche beim Schließen des Batteriefachs (7) einen Gegenkontakt (18) zum Schließen des Versorgungsstromkreises automatisch kontaktiert und zu Beginn eines Öffnungsvorgangs des Batteriefachs (7) den Gegenkontakt automatisch wieder freigibt, dass die zumindest eine Batterie (5, 6) als Standardbatterie (5, 6) ausgeführt ist und dass der Gehäuseteil (14) des Batteriefachs (7) mit dem Deckel (15) durch einen Schraubverschluss (16) verschließbar ist und der elektrische Kontakt (18, 19) im Versorgungsstromkreis (18...25) nur dann eine Verbindung herstellt, wenn der Schraubverschluss (16) derart weit eingedreht ist, dass die Anforderungen für einen Einsatz in explosionsgefährdeten Bereichen aufgrund der besonderen Eigenschaft des Schraubverschlusses (16) erfüllt sind, dass dieser die Funktion einer ausreichenden Zünd- oder Flammensperre besitzt.

2. Feldgerät nach Anspruch 1, **dadurch gekennzeichnet,**
**dass** die zumindest eine Batterie (5, 6) im Wesentlichen zylinderförmig ist, wobei sich jeweils ein Batteriekontakt (8...11) an den Grundflächen des Zylinders befindet,
**dass** die zumindest eine Batterie mit einem ersten Batteriekontakt (8, 9) voraus bei geöffnetem Deckel (15) in den Batterieschacht (12, 13) einführbar ist,
**dass** der Deckel im Wesentlichen becherförmig ausgebildet ist, wobei sich ein Deckelgewinde (17) zur Realisierung des Schraubverschlusses (16) im Bereich des Becherrands befindet, dass der Deckel an der Innenseite des Becherbodens mit einem elektrisch leitfähigen Element (18) zur Kontaktierung des zweiten Batteriekontakts (10, 11) versehen ist und
**dass** das elektrisch leitfähige Element (18) der Gegenkontakt für die Kontaktfahne (19) ist.

3. Feldgerät nach Anspruch 2, **dadurch gekennzeichnet, dass** der Batterieschacht (12, 13) und die Kontaktfahne (19) jeweils mit einer Feder (20...22) zum Andrücken der zumindest einen Batterie (5, 6) bzw. der Kontaktfahne (19) gegen das elektrisch leitfähige Element (18) im geschlossenen Zustand des Batteriefachs (7) versehen sind.

## Claims

1. Field device for process instrumentation, in particular a measuring transducer (1), actuator or mobile operating device, which is suitable for use in areas subject to explosion hazards,
having an electronic unit (3) which is arranged in a housing (4) of the field device (1), and
having at least one replaceable battery (5, 6) for supplying the electronic unit with auxiliary energy required for its operation,
the at least one battery (5, 6) being arranged in a battery compartment (7) which is situated in a housing part (14) of the field device (1) with a cover (15) which can be removed in order to replace the battery, and
the housing part (14) to be opened and/or the cover (15) having a battery chamber (12, 13) for accommodating the at least one battery (5, 6) in the correct position, **characterized in that** an electrical contact (18, 19) in a circuit (18...25) for supplying the electronic unit (3) with the auxiliary energy provided by the at least one battery (5, 6) is in the form of a contact lug (19) which, when closing the battery compartment (7), automatically makes contact with a mating contact (18) for closing the supply circuit and automatically releases the mating contact again at the start of an opening operation of the battery compartment (7) **in that** the at least one battery (5, 6) is in the form of a standard battery (5, 6), and **in that** the housing part (14) of the battery compartment (7) can be closed with the cover (15) by means of a screw closure (16), and the electrical contact (18, 19) in the supply circuit (18...25) establishes a connection only when the screw closure (16) has been screwed in to such an extent that the requirements for use in areas subject to explosion hazards have been met on account of the special property of the screw closure (16) whereby the latter has the function of an adequate ignition barrier or flame arrester.

2. Field device according to Claim 1, **characterized in that** the at least one battery (5, 6) is substantially cylindrical, a respective battery contact (8...11) being situated on the base surfaces of the cylinder,
**in that** a first battery contact (8, 9) of the at least one battery can be inserted first into the battery chamber (12, 13) when the cover (15) is open,
**in that** the cover is substantially cup-shaped, the cover thread (17) for implementing the screw closure (16) being situated in the region of the edge of the cup,
**in that** the cover is provided, on the inside of the cup base, with an electrically conductive element (18) for making contact with the second battery contact (10, 11), and
**in that** the electrically conductive element (18) is the mating contact for the contact lug (19).

3. Field device according to Claim 2, **characterized in that** the battery chamber (12, 13) and the contact lug (19) are each provided with a spring (20...22) for pressing the at least one battery (5, 6) or contact lug (19) against the electrically conductive element (18) in the closed state of the battery compartment (7).

## Revendications

1. Appareil de terrain pour l'instrumentation des procédés, notamment transducteur (1) de mesure, actionneur ou appareil mobile de commande, qui est propre à une utilisation dans des endroits où existe un danger d'explosion,
comprenant une unité (3) électronique, qui est disposée dans un boîtier (4) de l'appareil (1) de terrain,
comprenant au moins une batterie (5, 6) remplaçable d'alimentation de l'unité électronique en de l'énergie auxiliaire nécessaire à son fonctionnement,
dans lequel la au moins une batterie (5, 6) est disposée dans un casier (7) de batterie, qui se trouve dans une partie (14) du boîtier de l'appareil (1) de terrain ayant un couvercle (15), qui peut être enlevé pour remplacer la batterie, et
dans lequel la partie (14) du boîtier à ouvrir et/ou le couvercle (15) a un puits (12, 13) de batterie pour la réception correcte en position de la au moins une batterie (5, 6),
**caractérisé en ce qu'**un contact (18, 19) électrique dans un circuit (18...25) d'alimentation de l'unité (3) électronique en l'énergie auxiliaire fournie par la au moins une batterie (5, 6) est réalisé sous la forme d'une cosse (19) de contact, qui, à la fermeture du casier (7) de la batterie, contacte automatiquement un contre-contact (18) de fermeture du circuit d'alimentation et, au début d'une opération d'ouverture du casier (7) de la batterie, relibère automatiquement le contre-contact, **en ce que** la au moins une batterie (5, 6) est réalisée sous la forme d'une batterie (5, 6) normalisée et **en ce que** la partie (14) du boîtier du casier (7) de la batterie peut être fermée par le couvercle (15) par une fermeture (16) par vis et le contact (18, 19) électrique dans le circuit (18...25) d'alimentation ne ménage une liaison que si la fermeture (16) par vissage est vissée tellement que les exigences pour une utilisation dans des endroits menacés du danger d'une explosion sont satisfaites, en raison de la propriété particulière de la fermeture (16) par vissage, **en ce que** celle-ci possède la fonction d'un arrêt suffisant d'inflammation ou de flamme.

2. Appareil de terrain suivant la revendication 1, **caractérisé en ce que** la au moins une batterie (5, 6) est de forme sensiblement cylindrique, un contact (8...11) de la batterie se trouvant respectivement sur la surface de base du cylindre, **en ce que** la au moins une batterie peut, par un premier contact (8, 9) de batterie, être introduite à l'avance, alors que le couvercle (15) est ouvert dans le puits (12, 13) pour la batterie,
**en ce que** le couvercle est constitué sensiblement en forme de coupe, un filetage (17) du couvercle se trouvant dans la partie du bord de la coupe pour la réalisation de la fermeture (16) par vissage,
**en ce que** le couvercle est pourvu, sur la face intérieure du fond de la coupe, d'un élément (18) conducteur de l'électricité pour la mise en contact du deuxième contact (10, 11) de la batterie et
**en ce que** l'élément (18) conducteur de l'électricité est le contre-contact pour la cosse (19) de contact.

3. Appareil de terrain suivant la revendication 2, **caractérisé en ce que** le puits (12, 13) pour la batterie et la cosse (19) de contact sont pourvus respectivement d'un ressort (20...22) de poussée de la au moins une batterie (5, 6) ou de la cosse (19) de contact sur l'élément (18) conducteur de l'électricité, lorsque le casier (7) de la batterie est à l'état fermé.
